(19) Europäisches Patentamt
European Patent Office
Office européen des brevets

(11) EP 2 544 017 A1

(12) EUROPEAN PATENT APPLICATION

(43) Date of publication:
09.01.2013 Bulletin 2013/02

(51) Int Cl.:
$G01R\ 33/36\ ^{(2006.01)}$

(21) Application number: 11172486.0

(22) Date of filing: 04.07.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicants:
• Koninklijke Philips Electronics N.V.
5621 BA Eindhoven (NL)
• Philips Intellectual Property & Standards GmbH
20099 Hamburg (DE)

(72) Inventors:
• Luedeke, Kai-Michael
5600 AE Eindhoven (NL)

• Nehrke, Kay
5600 AE Eindhoven (NL)
• Katscher, Ulrich
5600 AE Eindhoven (NL)
• Boernert, Peter
5600 AE Eindhoven (NL)

(74) Representative: Damen, Daniel Martijn
Philips
Intellectual Property & Standards
P.O. Box 220
5600 AE Eindhoven (NL)

(54) **Magnetic resonance imaging system with a fixed output amplitude transmitter**

(57) The invention relates to a magnetic resonance imaging system for acquiring magnetic resonance data from a subject within an imaging volume. The magnetic resonance imaging system comprises a transmitter for generating radio-frequency pulses (708) for exciting atomic nuclei within the imaging volume using a radio-frequency antenna. The transmitter has a fixed output amplitude and a modulated output. The transmitter is configured to generate the radio-frequency pulses by switching radio-frequency emissions at the fixed output amplitude on and off. The transmitter is further configured to generate the radio-frequency pulses by controlling the modulated output. The magnetic resonance imaging system further comprises a receiver for receiving radio-frequency emissions from the excited atomic nuclei using the radio-frequency antenna.

FIG. 7

**Description**

TECHNICAL FIELD

The invention relates to magnetic resonance imaging, in particular to the radio-frequency system of magnetic resonance imaging systems.

BACKGROUND OF THE INVENTION

A magnetic field is used in Magnetic Resonance Imaging to align the nuclear spins of atoms as part of the procedure for producing images within the body of a patient. This magnetic field is referred to as the BO field. During an MRI scan, Radio Frequency (RF) pulses generated by a transmitter or amplifier and an antenna cause perturbations to the local magnetic field and can be used to manipulate the orientation of the nuclear spins relative to the B0 field. RF signals emitted by the nuclear spins are detected by a receiver coil, and these RF signals are used to construct the MRI images.

Parallel Transmit Magnetic Resonance Imaging (MRI) systems have multiple transmit and receive channels. The antenna may comprise multiple antenna elements, each of which is connected to a transmitter and/or receiver. The Radio Frequency (RF) amplifiers for a multiple channel MRI system are expensive.

SUMMARY OF THE INVENTION

The invention provides for a magnetic resonance imaging system, a computer program product and a method in the independent claims. Embodiments are given in the dependent claims.

Embodiments of the invention may provide a means of reducing the cost of producing a magnetic resonance imaging system by using a radio-frequency transmitter which has a fixed output amplitude and a modulated output. The amplitude of the radio-frequency transmitter is either transmitting the fixed output level or it is turned off. However the output is able to be modulated. This means that the phase and/or the frequency of the radio-frequency signal that is generated is adjustable. Such a fixed output amplitude radio-frequency transmitter is less expensive that an equivalent radio-frequency transmitter with an adjustable output amplitude. This may result in significant cost savings when manufacturing a magnetic resonance imaging system.

In a conventional magnet resonance imaging system, also the amplitude of the radio-frequency signal is controlled. For instance the output amplitude may follow a Sinc function. Embodiments of the invention may use modulated radio-frequency pulses which are equivalent to conventional radio-frequency pulses.

A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example a data may be retrieved over a modem, over the internet, or over a local area network. References to a computer-readable storage medium should be interpreted as possibly being multiple computer-readable storage mediums. Various executable components of a program or programs may be stored in different locations. The computer-readable storage medium may for instance be multiple computer-readable storage medium within the same computer system. The computer-readable storage medium may also be computer-readable storage medium distributed amongst multiple computer systems or computing devices.

'Computer memory' or 'memory' is an example of a computer-readable storage medium. Computer memory is any memory which is directly accessible to a processor. Examples of computer memory include, but are not limited to: RAM memory, registers, and register files. References to 'computer memory' or 'memory' should be interpreted as possibly being multiple memories. The memory may for instance be multiple memories within the same computer system. The memory may also be multiple memories distributed amongst multiple computer systems or computing devices.

'Computer storage' or 'storage' is an example of a computer-readable storage medium. Computer storage is any non-volatile computer-readable storage medium. Examples of computer storage include, but are not limited to: a hard disk drive, a USB thumb drive, a floppy drive, a smart card, a DVD, a CD-ROM, and a solid state hard drive. In some embodiments computer storage may also be computer memory or vice versa. References to 'computer storage' or 'storage' should be interpreted as possibly being multiple storage. The storage may for instance be multiple storage devices within the same computer system or computing device. The storage may also be multiple storages distributed amongst multiple computer systems or computing devices.

A 'processor' as used herein encompasses an electronic component which is able to execute a program or machine executable instruction. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. Many programs have their instructions performed by multiple processors that may be within the same computing device or which may even be distributed across multiple computing devices.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, gear sticks, steering wheel, pedals, wired glove, dance pad, remote control, and accelerometer are all examples of user interface components which enable the receiving of information or data from an operator.

A 'hardware interface' as used herein encompasses a interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

'Magnetic Resonance (MR) data' as used herein encompasses the recorded measurements of radio frequency signals emitted by atomic spins by the antenna of a Magnetic resonance apparatus during a magnetic resonance imaging scan. A Magnetic Resonance Imaging (MRI) image is defined herein as being the reconstructed two or three dimensional visualization of anatomic data contained within the magnetic resonance imaging data. This visualization can be performed using a computer.

In one aspect the invention provides for a magnetic resonance imaging system for acquiring magnetic resonance data from a subject within an imaging volume. The magnetic resonance imaging system comprises a transmitter for generating radio-frequency pulses for exciting atomic nuclei within the imaging volume using a radio-frequency antenna. The transmitter has a fixed output amplitude and a modulated output. The transmitter may modulate the frequency and/or the phase of the radio-frequency energy generated by the transmitter. The transmitter is either transmitting at the fixed output amplitude or it is not transmitting at all so essentially the transmitter can be switched between a transmitting state and a non-transmitting state. When the transmitter is transmitting though the frequency of the output can be changed. This may for instance be accomplished by the transmitter having a phase control and/or a frequency control. Controlling the phase and the frequency are effectively equivalent. The transmitter is configured to generate the radio-frequency pulses by switching radio-frequency emissions at the fixed output amplitude on and off. The transmitter is further configured to generate the radio-frequency pulses by controlling the modulated output. The magnetic resonance imaging system further comprises a receiver for receiving radio-frequency emissions from the excited atomic nuclei using the radio-frequency antenna. The radio-frequency antenna may be a separate transmit coil attached to the transmitter and/or a separate receive coil connected to the receiver. Likewise the transmitter and the receiver may be combined into a single transceiver unit.

Embodiments of the invention have the advantage that the output is at a fixed level from the transmitter. Transmitters with a fixed output level are simpler and therefore less expensive than transmitters which also have a variable output amplitude or an amplitude which cannot be modulated. This means that for the same amount of money a more powerful transmitter may be used or a transmitter for lower cost may be used to replace a transmitter with an adjustable or modulatable output amplitude. Such a transmitter may be used to generate effectively equivalent radio-frequency pulses for exciting atomic nuclei.

In another embodiment the magnetic resonance imaging system further comprises a memory for storing machine executable instructions. The magnetic resonance imaging system further comprises a processor for controlling the magnetic resonance imaging system and for executing the machine executable instructions. Execution of the instructions causes the processor to receive a pulse sequence to acquire the magnetic resonance data. The pulse sequence comprises commands for controlling the switching of the radio-frequency emissions and for controlling the modulation of the transmitter to cause the generation of the radio-frequency pulses. Execution of the instructions causes the processor to acquire the magnetic resonance data using the pulse sequence.

This embodiment may be beneficial because the pulse sequence contains commands which enable the transmitter to generate radio-frequency pulses which are able to manipulate the orientation of atomic nuclei or spins within the imaging volume. The pulse sequence may contain a timing diagram which details when the transmitter should be switched on and off. Additionally the pulse sequence may comprise commands which are used to control the modulation of the transmitter.

In another embodiment the commands cause the transmitter to generate a phase-modulated multidimensional radio-frequency pulse and/or a frequency-modulated multidimensional radio-frequency pulse. Multidimensional radio-frequency pulses are multidimensional spatially-selective radio-frequency pulses which are able to generate or to refocus transverse magnetization within arbitrarily-shaped, spatially restricted areas in up to three spatial dimensions and potentially the spectral dimension in addition. In general spatially-selective radio-frequency pulses consist in a definite deposition of radio-frequency energy in the excitation k-space spanned by appropriate magnetic field gradients applied simultaneously. Such multidimensional radio-frequency pulses are well known in the literature.

The use of phase-modulated multidimensional radio-frequency pulses and/or frequency-modulated multidimensional radio-frequency pulses may be used to replace the radio-frequency pulses in any imaging technique. The phase-modulated multidimensional radio-frequency pulse and the frequency-modulated multidimensional radio-frequency pulses both have a constant or fixed output amplitude. This embodiment may be beneficial because the aforementioned multidimensional radio-frequency pulses may be used to be generated by the transmitter as described in an embodiment of the invention. This enables the use of imaging techniques using a less expensive transmitter.

In another embodiment the transmitter comprises multiple transmit channels. The radio-frequency antenna is a multi-element antenna. Each element of the antenna is connected to one of the multiple transmit channels. This embodiment may be beneficial because the use of multiple transmit channels permits more accurate and rapid imaging.

In another embodiment execution of the instructions cause the transmitter to generate a pulse-density modulated radio-frequency pulse. In this embodiment the transmitter is switched off and on to replicate the spectral form of a radio-frequency pulse with a variable amplitude. This is similar in idea to using a switching power supply to approximate an output voltage. The transmitter for instance may be switched on and off in such a pattern such that it is able to approximate a desired analogue waveform. In some embodiments this waveform may be directly used or in other embodiments the output of the transmitter may be put through a filter which causes the pulse-intensity modulated radio-frequency pulse to have an analogue modulated output. When a filter is used an external filter or possibly even the radio-frequency antenna may function as the filter or a portion of the filter.

In another embodiment the dwell time of the transmitter is shorter than the filter time constant of the radio-frequency antenna. This embodiment may be beneficial because the radio-frequency antenna then functions as a filter for the transmitter. This may reduce sidebands in the frequency domain of the pulse-density modulated radio-frequency pulse. This may result in a higher quality magnetic resonance image.

In another embodiment the pulse-density modulated radio-frequency pulse comprises radio-frequency pulses of equal amplitude.

In another embodiment the timing of the radio-frequency pulses is distributed in time to minimize spurious sidebands of the pulse-density modulated radio-frequency pulse. This may be accomplished for instance by having the pulses being of different durations. For instance, if the pulses are always the same duration then this may lead to a frequency or spectral component in the frequency domain. By changing the pulse width or time in an irregular fashion it may cause a reduction in the sidebands in the frequency domain.

In another embodiment the transmitter comprises multiple transmit channels. The radio-frequency antenna is a multi-element antenna. Each element of the antenna is connected to one of the multiple transmit channels. This embodiment may be particularly beneficial because a transmitter with a fixed output amplitude may be used for each of the multiple transmit channels. This may lead to a significant reduction in the price needed to manufacture the magnetic resonance imaging system.

In another embodiment each of the multiple transmit channels comprises a matching network. Each matching network is configured to be switched between a matched state and an unmatched state. In the matched state the impedance matched network matches the impedance of the transmitter to the element of the multi-element antenna. In the unmatched state there is an impedance mismatch between the transmit channel and the antenna element. Execution of the instructions causes the processor to generate commands which cause the processor to transmit only on a single transmit channel at a time. The single transmit channel is chosen from the multiple transmit channels. The matching network of the single transmit channel is in a matched state. The remaining multiple transmit channels are in an unmatched state. This embodiment may be beneficial because only a single element of the multi-element antenna is in a matched state. This may reduce or prevent couplings between the various channels. The transmitter is pulse-density modulated. The times when the various transmit channels transmit may be designed such that they are pulsed on during different time periods. This means that it is possible to operate a multiple transmit channel system and only transmit on one channel at a time. Switching the unused channels to an unmatched state prevents coupling to those multi-element antennas. This may greatly increase the resolution and quality of the magnetic resonance images generated.

In another embodiment each of the multiple transmit channels comprises a matching network. Each matching network is configured to be switched between a matched state and an unmatched state. Execution of the instructions causes the processor to generate commands which cause the processor to transmit only on a predetermined subset of the multiple transmit channels during a predetermined time period. The matching network of each of the predetermined subsets is in a matched state. All the multiple transmit channels not in the predetermined subset are in an unmatched state. This embodiment may have the same benefits as the previous embodiment except in this embodiment more than one of the multiple transmit channels is used. For instance in a multi-element antenna there may be elements which are spatially separated from each other and do not have a high degree of coupling between the two. These two or more elements of the multi-element antenna may therefore be operated with only minimal coupling between them. Therefore subsets of antennas which have a low degree of coupling between them may be operated at the same time. This may enable the acquisition of magnetic resonance data which is used to generate magnetic resonance images which have a higher image quality.

In another aspect the invention provides for a computer program product comprising machine executable instructions for execution by a processor. The processor is adapted for controlling a magnetic resonance imaging system for acquiring magnetic resonance data from a subject within an imaging volume. The magnetic resonance imaging system comprises a transmitter for generating radio-frequency pulses for exciting atomic nuclei within the imaging volume using a radio-frequency antenna. The transmitter has a fixed output amplitude and a modulated output. The transmitter is configured to generate the radio-frequency pulses by switching radio-frequency emissions at the fixed output amplitude on and off. The transmitter is further configured to generate the radio-frequency pulses by controlling the modulated output. The magnetic resonance imaging system further comprises a receiver for receiving the radio-frequency emissions from the excited atomic nuclei using the radio-frequency antenna. Execution of the instructions causes the processor to receive a pulse sequence to acquire the magnetic resonance data. The pulse sequence comprises commands for controlling the switching of the radio-frequency emissions and controlling the modulation of the transmitter to cause the generation of the radio-frequency pulses. Execution of the instructions further causes the processor to acquire the magnetic resonance data using the pulse sequence. The advantages of this embodiment have been previously discussed.

In another embodiment execution of the instructions further causes the processor to generate the pulse sequence. For instance the processor may be caused to calculate the commands to send to the transmitter to generate phase-modulated multidimensional radio-frequency pulses, frequency-modulated multidimensional radio-frequency pulses, and/or pulse-density modulated radio-frequency pulses.

In another aspect the invention provides for a method of controlling the magnetic resonance imaging system for acquiring magnetic resonance data from a subject within the imaging volume. The magnetic resonance imaging system comprises a transmitter for generating radio-frequency pulses for exciting atomic nuclei within the imaging volume using a radio-frequency antenna. The transmitter has a fixed output amplitude and a modulated output. The transmitter is configured to generate the radio-frequency pulses by switching radio-frequency emissions at the fixed output amplitude on and off. The transmitter is further configured to generate the radio-frequency pulses by controlling the modulated output. The magnetic resonance imaging system further comprises a receiver for receiving radio-frequency emissions from the excited atomic nuclei using the radio-frequency antenna. The method comprises the step of receiving a pulse sequence to acquire the magnetic resonance data. The pulse sequence comprises commands for controlling the switching of the radio-frequency emissions and for controlling the modulation of the transmitter to cause the generation of the radio-frequency pulses. The method further comprises the step of acquiring the magnetic resonance data using the pulse sequence.

BRIEF DESCRIPTION OF THE DRAWINGS

In the following preferred embodiments of the invention will be described, by way of example only, and with reference to the drawings in which:

Fig. 1 shows a flow chart which illustrates a method according to an embodiment of the invention;
Fig. 2 illustrates a magnetic resonance imaging system according to an embodiment of the invention;
Fig. 3 shows a checkerboard target pattern used in a simulation of an 8-channel body coil that was simulated for a homogeneous sphere.
Fig. 4 shows an approximation of Fig. 3 of an excitation pattern calculated using a first order Tikhonov regularization.
Fig. 5 shows the radio-frequency waveforms of the 8 transmitting channels for a simulation;
Fig. 6A shows the time domain plot of a pulse-density modulated binary radio-frequency pulse;
Fig. 6B shows the same RF pulse shown in Fig. 6A but in the frequency domain;

Fig. 6C shows a Sinc-shaped radio-frequency pulse in the time domain;
Fig. 6D shows the same RF pulse shown in Fig. 6C but in the frequency domain;
Fig. 7 shows several images used to illustrate the effectiveness of using a bit-stream Sinc pulse or a pulse-density modulated radio-frequency pulse; and
Fig. 8 illustrates a multi-channel, de-tunable matching network 800

## DETAILED DESCRIPTION OF THE EMBODIMENTS

Like numbered elements in these figures are either equivalent elements or perform the same function. Elements which have been discussed previously will not necessarily be discussed in later figures if the function is equivalent.

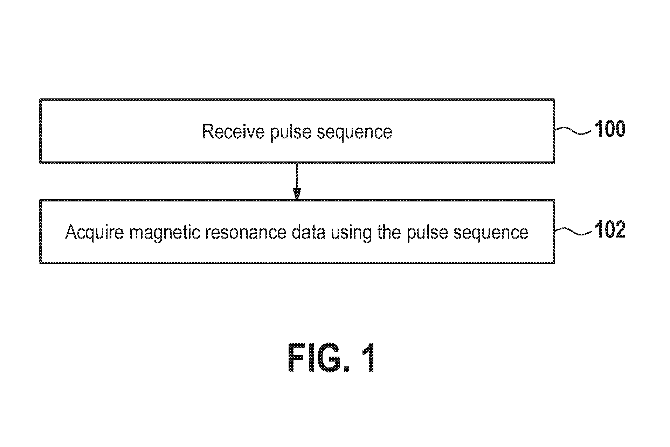

Fig. 1 shows a flow diagram which illustrates a method according to an embodiment of the invention. First in step 100 a pulse sequence is received. Next in step 102 magnetic resonance data is acquired using the pulse sequence. The pulse sequence comprises commands for controlling the switching of a radio-frequency emission emitted by a transmitter. The pulse sequence further comprises commands for controlling the modulation of the transmitter to cause the generation of the radio-frequency pulses. The transmitter has a fixed output amplitude and a modulated output. The transmitter is configured to generate the radio-frequency pulses by switching radio-frequency emissions at the fixed output amplitude on and off. The transmitter is further configured to generate the radio-frequency pulses by controlling the modulated output.

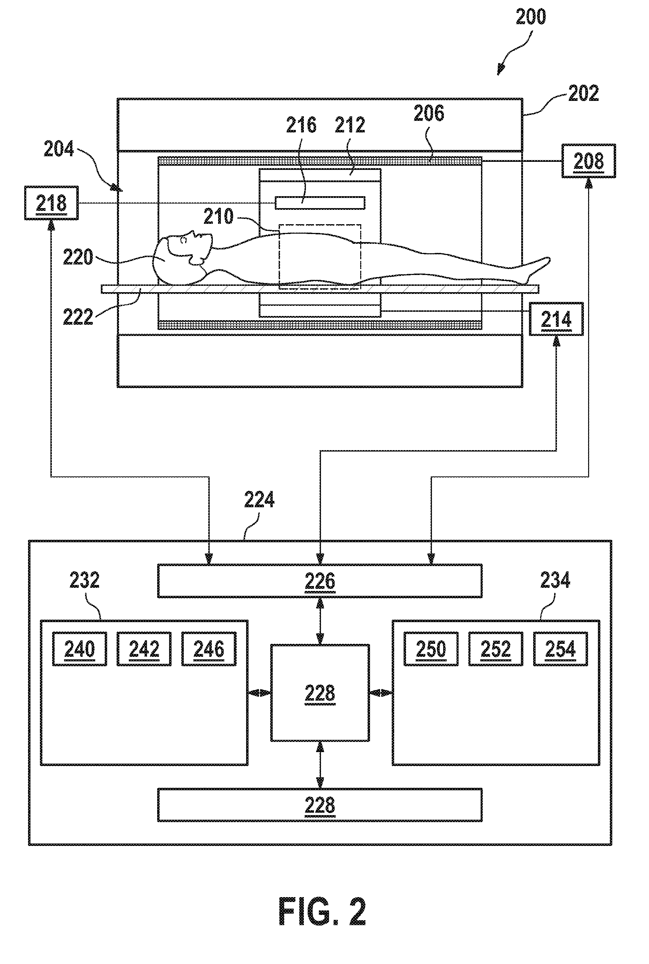

Fig. 2 shows an example of a magnetic resonance imaging system 200 according to an embodiment of the invention. The magnetic resonance imaging system 200 comprises a magnet 202. The magnet 202 shown in this example is a cylindrical type superconducting magnet 202 with a bore 204. The magnet 202 has a liquid helium cooled cryostat with superconducting coils. It is also possible to use permanent or resistive magnets. The use of different types of magnets is also possible for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils. Within the bore 204 of the cylindrical magnet there is an imaging zone 210 where the magnetic field is strong and uniform enough to perform magnetic resonance imaging.

Within the bore of the magnet 204 is a set of magnetic field gradient coils 206 which are used for acquisition of magnetic resonance data to spatially encode magnetic spins within an imaging zone of the magnet. The magnetic field gradient coils 206 are connected to a magnetic field gradient coil power supply 208. The magnetic field gradient coil is representative. Typically magnetic field gradient coils 206 contain three separate sets of coils for spatially encoding in three orthogonal spatial directions. A magnetic field gradient power supply 208 supplies current to the magnetic field gradient coils. The current supplied to the magnetic field coils is controlled as a function of time and may be ramped or pulsed.

Surrounding the imaging zone 210 is a transmit coil 212. The transmit coil 212 is connected to a transmitter 214. The transmit coil 212 and the transmitter 214 may have a single channel or it may have multiple channels and coil elements. The transmit coil 214 is used to transmit radio-frequency energy for manipulating the spins located within the imaging zone 210. Also adjacent to the imagine zone 210 is a receive coil 216. The receive coil 216 is connected to a receiver 218. Receiver 218 is adapted for receiving and recording the magnetic resonance data.

A subject 220 is shown partially within the imaging zone 210 and is reposing on a subject support 222. The magnetic field gradient coil power supply 208, the transmitter 214 and the receiver 218 are shown as being connected to a hardware interface 226 of a computer system 224. The computer system 224 further comprises a processor 228 which is connected to the hardware interface 226, a user interface 230, computer storage 232, and computer memory 234. The computer processor 228 uses the hardware interface 226 to send and receive commands to the other components of the magnetic resonance imaging system 200. Via the hardware interface 226 the processor 228 is able to control the operation and function of the magnetic resonance imaging system 200. Within the computer storage 232 is shown a magnetic resonance data 240 that was acquired from the subject 220. Also shown within the computer storage 232 is a magnetic resonance image 242 that was reconstructed from the magnetic resonance data 240. Also shown in computer storage 232 is a pulse sequence 246. The pulse sequence 246 contains commands and instructions the processor 228 used to control the magnetic resonance imaging system 200 to acquire the magnetic resonance data 240.

The computer memory 234 is shown as containing a control module 250. The control module contains computer executable code which allows the processor 228 to control the operation and function of the magnetic resonance imaging system 200. The computer memory 234 further contains an image reconstruction module 252. The image reconstruction module 252 contains computer executable code which the processor 228 uses to reconstruct the magnetic resonance data 240 into the magnetic resonance image 242. The computer storage 234 further contains a pulse sequence generation module 254. The pulse sequence generation module 254 contains computer executable code which the processor 228 may use to generate a pulse sequence such as 246. The pulse sequence generation module 254 in particular may contain code for generating commands which enable the transmitter to generate a phase-modulated multidimensional radio-frequency pulse, a frequency-modulated multidimensional radio-frequency pulse, and/or a pulse-density modulated radio-frequency pulse.

The transmitter 214 has a fixed output amplitude and a modulated output. The modulated output may be in control of the frequency or phase modulation of the RF signal. The transmitter 214 may also further be switched between an on and an off state.

Cost reduction is a major topic in manufacturing MR systems. An important, cost-driving component is the Radio Frequency (RF) amplifier, especially for Parallel Transmit Magnetic Resonance Imaging (MRI) systems, because several of them needed. A possibility for cost reduction and efficiency optimization is to use RF generators with limited modulation functionality, i.e., capable only of phase (frequency) modulation and fixed amplitude settings per sequence, waiving the possibility of amplitude modulation. For this purpose in particular modem switchmode Class D/E/F DC-to-RF-invertors come into consideration to replace the present day Class AB linear amplifiers. These RF-generators can achieve almost 100 % efficiency which rewards the above amplitude constraint (is proportional to supply voltage rather than input amplitude) with reduced operational cost, reduced heat dissipation, reduced effort for heat removal.

For spatially selective RF pulses, amplitude modulation of the RF waveform may be circumvented by appropriate stretching or condensing of the excitation k-space traversal (the VERSE principle). However, this approach has several disadvantages, e.g., (1) in a typical MR system, the time steps are multiples of a fixed dwell time and cannot be stretched arbitrarily, (2) the pulse duration (and thus, sequence timing) changes unpredictably with the desired target pattern, (3) the resulting, required gradients are amplitude modulated, and hence, limited by the gradient amplifier performance with respect to gradient strength, slew-rate and fidelity.

For Parallel Transmit MRI systems, additional problems arise due to the coupling between the individual Tx coil elements, resulting in e.g. low power efficiency of the coil array. This is a general problem of Parallel Transmission, which is not related to the specific RF pulse waveforms.

Embodiments of the invention may provide two different methods to address the above-mentioned problems:

First, a method is proposed to design multi-dimensional RF pulses with constant amplitudes in the framework of parallel transmission. A fixed dwell time is assumed, i.e., the spatial encoding is performed by suitable phase modulations of the waveforms of the different TX channels.

Second, a method is proposed to employ a switching amplifier in combination with pulse density modulation (PDW) for RF pulse generation. In this concept, the RF pulses are physically represented by bit-streams, i.e. a (non-equidistant) series of short RF pulses with fixed amplitudes clocked out with a high but fixed frequency. For parallel transmission, disjunct bit-streams are employed for each individual channel, preferably highly synchronised, allowing furthermore high mutual decoupling of the channels by fast detuning of the non-active coil elements.

In the framework of parallel transmission, multi-dimensional waveforms can be calculated using:

$$\underline{T} = \underline{\underline{S}}\,\underline{W} \ . \tag{1}$$

The vector $\underline{T}$ contains the desired excitation pattern and the vector $\underline{W}$ contains the concatenated waveforms of the different TX channels. The matrix $\underline{\underline{S}}$ contains the coil sensitivities. The variables $\underline{T}$, $\underline{\underline{S}}$, and $\underline{W}$ are complex quantities including amplitude and phase. Since Eq. (1) is linear, it can be solved via (regularized) pseudo-inversion (indicated by "+")

$$\underline{W} = \underline{\underline{S}}^{+}\,\underline{T} \ . \tag{2}$$

For the proposed invention, the amplitude $A_n$ of $\underline{W}(t)$ has to be fixed for each channel $n$, i.e.,

$$\underline{W}'(t) = A_n \exp(i\varphi(t)) \ . \tag{3}$$

Using $\underline{W}'$ instead $\underline{W}$, Eq. (1) becomes non-linear, and has to be solved iteratively instead via matrix inversion.

This time-consuming method is able to yield optimum results. Alternatively, Eq. (1) can be solved via matrix inversion, however employing first order Tikhonov regularization, which smoothes amplitude and phase of the waveforms. In a second step, the smooth amplitudes of the resulting waveforms are set to a constant value. This method yields sub-optimal results, but requires much less CPU time than the iterative method described above.

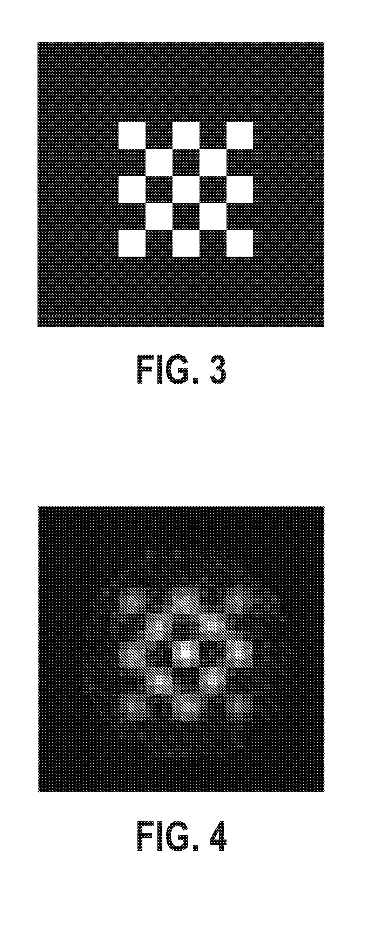

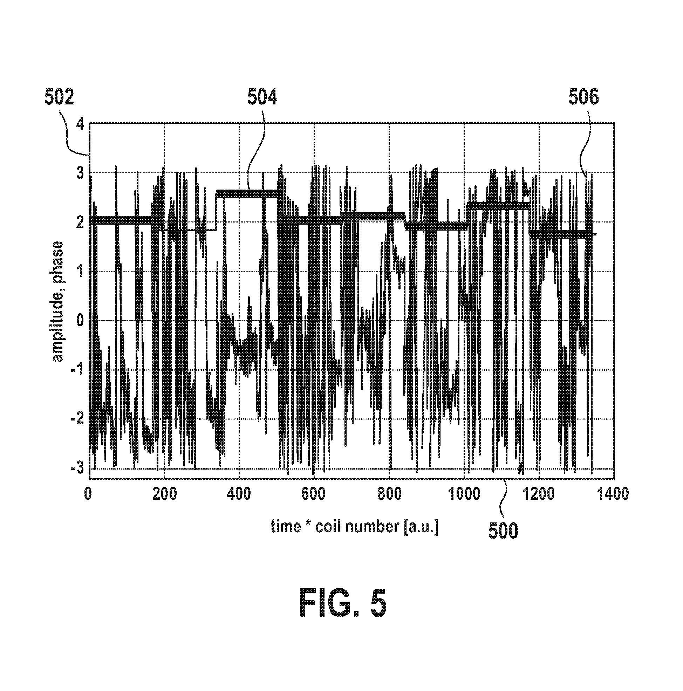

The TX sensitivities of an eight-channel body coil were simulated for a homogeneous sphere. A checkerboard target pattern $\underline{T}$ (see Fig. 3) and a spiral k-space trajectory with a reduction factor R=2 were chosen. The "quick-and-dirty" alternative of the above described algorithms was used, i.e., Eq. (1) was solved via pseudo-inversion of $\underline{\underline{S}}$ with 1. order Tikhonov regularization. The amplitudes of the waveforms were set constant to the time-average of the respective TX channel (see Fig. 5). The resulting excitation pattern is given in Fig. 4. It has a correlation of roughly 90% with Fig. 3.

Fig. 3 shows a checkerboard target pattern used in a simulation of an 8-channel body coil that was simulated for a homogeneous sphere.

Fig. 4 shows an approximation of Fig. 3 of an excitation pattern calculated using a first order Tikhonov regularization.

Fig. 5 shows the radio-frequency waveforms of the 8 transmitting channels for the simulation. The x-axis 500 shows the time axis in arbitrary units and is divided by individual coil numbers 1-8. The y-axis 502 shows both the amplitude and phase of the waveforms. The connected curves labeled 504 show the waveform amplitudes and the constant for each transmit channel. The connected lines 506 show waveform phases which are unconstrained. The plotted waveforms shown in Fig. 5 achieve the excitation pattern shown in Fig. 4.

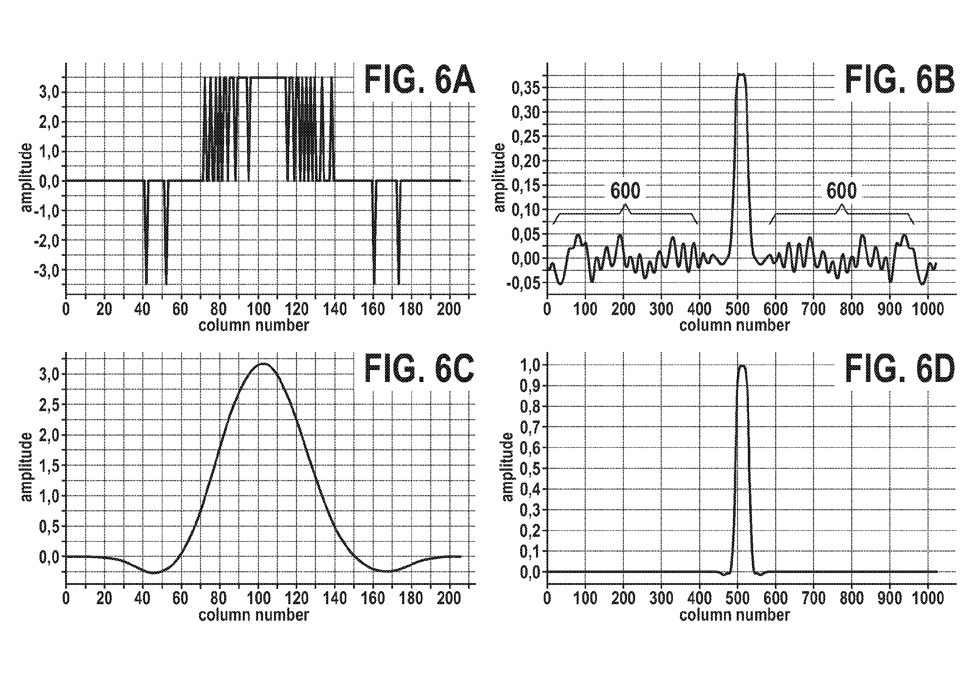

Fig. 6 is used to illustrate the pulse-density modulated radio-frequency pulses. Fig. 6a shows the time domain plot of a pulse-density modulated binary radio-frequency pulse. Fig. 6b shows the same RF pulse shown in Fig. 6a but in the frequency domain. Fig. 6c shows a Sinc-shaped radio-frequency pulse in the time domain. Fig. 6d shows the RF pulse of Fig. 6c in the frequency domain. The pulse-density modulated binary radio-frequency pulse of Fig. 6a is an approximation of the Sinc-shaped radio-frequency pulse of Fig. 6c. In comparing the frequency domain of the binary radio-frequency pulse in Fig. 6b with that of the Sinc-shaped radio-frequency pulse in 6d it can be seen that they are extremely similar. It can be seen in Fig. 6b that the effect of using the pulse-density modulated binary radio-frequency pulse is that there are sidebands 600 which are not present in Fig. 6d.

The principle of pulse density modulation, which is well known for switchmode power amplifiers (e.g. Class D/E/F "amplifier"), is illustrated in Fig.6 for a slice-selective RF pulse. The RF pulse is composed of a "bit-stream" of elementary pulses of equal height as shown in Fig. 6A. The density of the elementary pulses is chosen according to the desired Sinc waveform. The spectral selectivity in Fig. 6B shows the requested slice profile and additional spurious out-of-slice contributions. Low-pass filtering of the bit-stream RF pulse shown in Fig. 6C results in a conventional RF Sinc-waveform used for slice selection with the known, clean excitation profile without spurious side bands shown in Fig 6d.

In an MRI system, the required filtering of the RF pulse is done automatically by the TX RF coil, if the dwell time of the RF amplifier is chosen considerably shorter than the filtering time constant of the coil. The latter is approx. 1 us, hence, dwell times in the order of 100ns or shorter would be required.

If the dwell time is chosen larger than the filter time constant of the coil, the excitation profile would likely be contaminated by spurious RF excitation. This could be addressed by advanced RF pulse design, incorporating these effects into the RF pulse design problem. E.g. the elementary pulses could be arranged appropriately to distribute the spurious RF contributions randomly in space. Moreover, the binary pattern could be varied for the different phase encoding steps required for image formation to further randomize the effects and to reduce the undesired out-of-slice excitation phenomena. Parallel transmission is another option to improve the RF performances. Different RF pulses with different RF waveforms can be used for the individual channels as a solution to the RF pulse design problem to further address the unwanted excitation effects.

Furthermore, in parallel transmission such a binary RF pulse approach can be even more advantageous. The transmit (Tx) array can be driven in a way that only a subset of the array is active for each point of the sampled RF waveform. For the corresponding time point all other non-active array parts could be actively be detuned, reducing coupling between the sub-sets significantly. This scheme can be applied also for each individual Tx coil element by fast detuning of the non-active channels. Such an approach is advantageously because it can help to reduce the amount of actual mutual Tx coupling. In this way less energy is reflected during transmission, reducing the requirements for the circulators to burn this amount of power. As a consequence of the reduced coupling RF power is used more efficiently, that might help to reduce the power requirements for the individual amplifiers involved. The improved Tx decoupling could also be beneficial to reduce potential patient heating (lower SAR) due to the effectively reduced Tx coil coupling.

A basic experimental validation of the concept has been performed on a 3T parallel transmit MRI system on phantoms. A bit-stream Sinc pulse has been implemented and its performance has been compared to conventional Sinc pulses of the scan software library. The selection gradients have been turned to the measurement direction to allow inspection of the slice profile. As expected from the simulations, the bit-stream RF pulse leads to slice definition comparable to that of a conventional Sinc pulse. In addition, spurious contributions are visible. This is due to the rather long dwell time of the RF waveform (6.4 us), resulting in an essentially unfiltered bit-stream RF pulse.

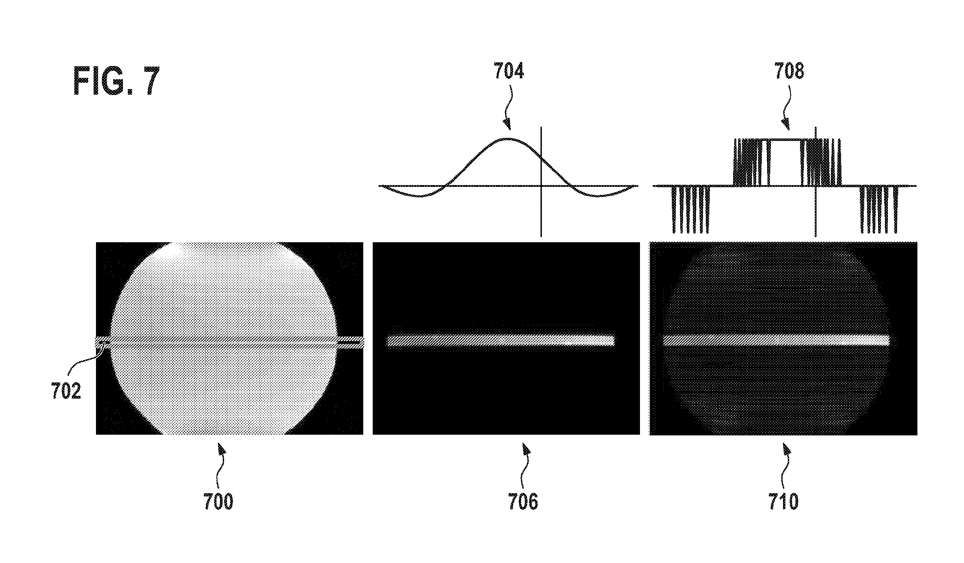

Fig. 7 illustrates the effectiveness of using a bit-stream Sinc pulse or a pulse-density modulated radio-frequency pulse. In Fig. 7 several images are shown. Image 700 is a phantom. The region 702 shows a slice selected from the image of the phantom 700. The curve 704 illustrates a Sinc pulse that is used to select the slice 702 for imaging. Image 706 shows an image of the slice 702 that was acquired using a radio-frequency pulse which has a Sinc-shape such as 704. In comparison the curve 708 illustrates a bit-stream Sinc pulse used to approximate the pulse 704. The image 710 shows a magnetic resonance image acquired using the bit-stream Sinc pulse 708. In comparing images 706 and 710 it can be seen that the slice region 702 is extremely similar. The additional lines surrounding the slice 702 in image 710 are caused by the sidebands as were shown in Fig. 6b 600.

The described method of pulse-density modulated RF pulses was discussed using the example of standard 1D (slice selective) RF excitation. However, it is straight forward to extend this concept to the multi-dimensional RF pulses as used in the discussion of the phase-modulated RF pulses.

The invention can be applied in all cases where spatially selective pulses are required (e.g., navigator pulses) using a low cost MR system, i.e., the RF amplifiers are capable only of phase (frequency) modulation and fixed amplitude settings per sequence for the sake of cost-reduction.

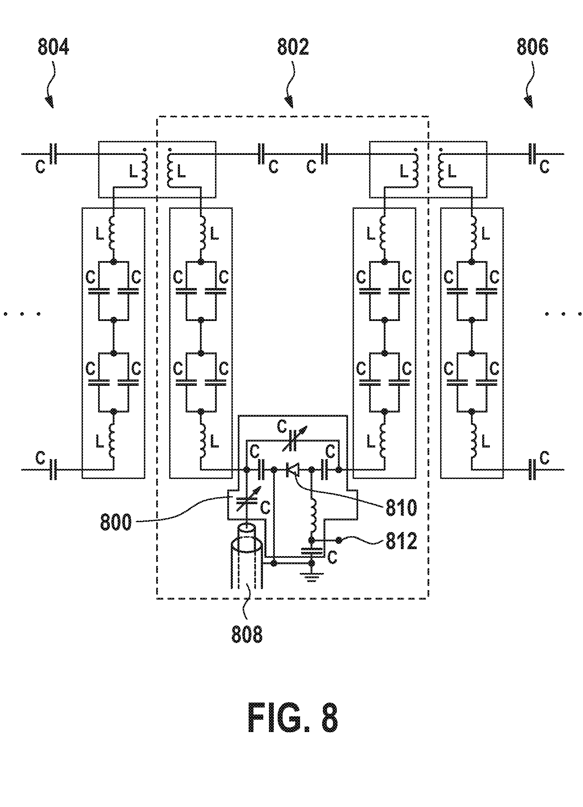

Fig. 8 shows an example of a de-tunable matching network 800. In Fig. 8 there is shown a coil element 802. Next to coil element 802 is adjacent coil element 804 and adjacent coil element 806. There is a cable 808 which connects to the matching network 800. In this example the matching network is integrated into the coil element 802. There is a pin diode 810 which may be used to detune the matching network 800. By applying a suitable DC voltage to pin 812 the pin diode 810 can be used to detune the matching network 800. By using such a matching network 800 coil elements 802, 804, 806 may be selectively detuned during execution of a pulse sequence. This can be used to have only a single coil element or multiple coil elements which are active at a particular time. The bit stream radio-frequency pulse sent to the different radio-frequency coils can be multiplexed such that only one or a group of coil elements is actively transmitting at a single time. This may be used to eliminate or reduce coupling between different coil elements.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

LIST OF REFERENCE NUMERALS

200    magnetic resonance imaging system

202    magnet

204    bore of magnet

206    magnetic field gradient coil

208    magnetic field gradient coil power supply

210    imaging zone

212    transmit coil

214    transmitter

| 216 | receive coil |
|-----|--------------|
| 218 | receiver |
| 220 | subject |
| 222 | subject support |
| 224 | computer |
| 226 | hardware interface |
| 228 | processor |
| 230 | user interface |
| 232 | computer storage |
| 234 | computer memory |
| 240 | magnetic resonance data |
| 242 | magnetic resonance image |
| 246 | pulse sequence |
| 250 | control module |
| 252 | image reconstruction module |
| 254 | pulse sequence generation module |
| 600 | sideband noise |
| 700 | phantom |
| 702 | slice |
| 704 | Sinc pulse |
| 706 | resulting slice |
| 708 | bit-stream Sinc pulse |
| 710 | resulting slice |
| 800 | matching network |
| 802 | coil element |
| 804 | adjacent coil element |
| 806 | adjacent coil element |
| 808 | cable connection |
| 810 | pin diode |

812 control

**Claims**

1. A magnetic resonance imaging system (200) for acquiring magnetic resonance data (240) from a subject (220) within an imaging volume (210) , the magnetic resonance imaging system comprising:

   - a transmitter (208) for generating radio-frequency pulses (506, 708) for exciting atomic nuclei within the imaging volume using a radio-frequency antenna (206), wherein the transmitter has a fixed output amplitude and a modulated output, wherein the transmitter is configured to generate the radio-frequency pulses by switching radio-frequency emissions at the fixed output amplitude on and off, wherein the transmitter is further configured to generate the radio-frequency pulses by controlling the modulated output; and
   - a receiver (218) for receiving radio-frequency emissions from the excited atomic nuclei using the radio-frequency antenna (216).

2. The magnetic resonance imaging system of claim 1, wherein the magnetic resonance imaging system further comprises:

   - a memory (234) for storing machine executable instructions (250, 252, 254);
   - a processor (228) for controlling the magnetic resonance imaging system and for executing the machine executable instructions, wherein execution of the instructions causes the processor to:
   - receive (100) a pulse sequence (246) to acquire the magnetic resonance data, wherein the pulse sequence comprises commands for controlling the switching of the radio-frequency emissions and controlling the modulation of the transmitter to cause the generation of the radio-frequency pulses; and
   - acquire (102) the magnetic resonance data using the pulse sequence.

3. The magnetic resonance imaging system of claim 2, wherein the commands cause the transmitter to generate a phase-modulated multidimensional radio-frequency pulse and/or a frequency-modulated multidimensional radio-frequency pulse.

4. The magnetic resonance imaging system of claim 3, wherein the transmitter comprises multiple transmit channels, wherein the radio-frequency antenna is a multi-element antenna, wherein each element of the antenna is connected to one of the multiple transmit channels.

5. The magnetic resonance imaging system of claim 2, wherein execution of the instructions causes the transmitter to generate a pulse-density modulated radio-frequency pulse.

6. The magnetic resonance imaging system of claim 5, wherein the dwell time of the transmitter is shorter than the filter time constant of the radio-frequency antenna.

7. The magnetic resonance imaging system of claim 5 or 6, wherein the pulse-density modulated radio-frequency pulse comprises radio frequency pulses of equal amplitude.

8. The magnetic resonance imaging system of claim 8, wherein the timing of the radio frequency pulses is distributed in time to minimize spurious sidebands (600) of the pulse-density modulated radio-frequency pulse.

9. The magnetic resonance imaging system of any one of claims 5 through 8, wherein the transmitter comprises multiple transmit channels, wherein the radio-frequency antenna is a multi-element antenna, wherein each element of the antenna is connected to one of the multiple transmit channels.

10. The magnetic resonance imaging system of claim 9, wherein each of the multiple transmit channels comprises a matching network (800), wherein each matching network is configured to be switched between a matched state and an unmatched state, wherein execution of the instructions causes the processor to generate commands which cause the processor to transmit only on a single transmit channel at a time, wherein the single transmit channel is chosen from the multiple transmit channels, wherein the matching network of the single transmit channel is in a matched state, wherein the remaining multiple transmit channels are in an unmatched state.

**11.** The magnetic resonance imaging system of claim 9, wherein each of the multiple transmit channels comprises a matching network (800), wherein each matching network is configured to be switched between a matched state and an unmatched state, wherein execution of the instructions causes the processor to generate commands which cause the processor to transmit only on a predetermined subset of the multiple transmit channels during a predetermined time period, wherein the matching network of each of the predetermined subset is in a matched state, wherein all of the multiple transmit channels not in the predetermined subset are in an unmatched state.

**12.** A computer program product comprising machine executable instructions (250, 252, 254) for execution by a processor (228), wherein the processor is adapted for controlling a magnetic resonance imaging system (200) for acquiring magnetic resonance data (240) from a subject (220) within an imaging volume (210), the magnetic resonance imaging system comprises a transmitter (2214) for generating radio-frequency pulses (506, 708) for exciting atomic nuclei within the imaging volume using a radio-frequency antenna (212), wherein the transmitter has a fixed output amplitude and a modulated output, wherein the transmitter is configured to generate the radio-frequency pulses by switching radio-frequency emissions at the fixed output amplitude on and off, wherein the transmitter is further configured to generate the radio-frequency pulses by controlling the modulated output, wherein the magnetic resonance imaging system further comprises a receiver for receiving radio-frequency emissions from the excited atomic nuclei using the radio-frequency antenna, wherein execution of the instructions causes the processor to:

- receive (100) a pulse sequence (246) to acquire the magnetic resonance data, wherein the pulse sequence comprises commands for controlling the switching of the radio-frequency emissions and controlling the modulation of the transmitter to cause the generation of the radio-frequency pulses; and
- acquire (102) the magnetic resonance data using the pulse sequence.

**13.** A method of controlling a magnetic resonance imaging system for acquiring magnetic resonance data (240) from a subject (220) within an imaging volume (210), the magnetic resonance imaging system comprises a transmitter (214) for generating radio-frequency pulses (506, 708) for exciting atomic nuclei within the imaging volume using a radio-frequency antenna (212), wherein the transmitter has a fixed output amplitude and a modulated output, wherein the transmitter is configured to generate the radio-frequency pulses by switching radio-frequency emissions at the fixed output amplitude on and off, wherein the transmitter is further configured to generate the radio-frequency pulses by controlling the modulated output, wherein the magnetic resonance imaging system further comprises a receiver (218) for receiving radio-frequency emissions from the excited atomic nuclei using the radio-frequency antenna (216), wherein the method comprises the steps of:

- receiving (100) a pulse sequence (246) to acquire the magnetic resonance data, wherein the pulse sequence comprises commands for controlling the switching of the radio-frequency emissions and controlling the modulation of the transmitter to cause the generation of the radio-frequency pulses, and
- acquiring (102) the magnetic resonance data using the pulse sequence.

| Receive pulse sequence | ~100 |

Acquire magnetic resonance data using the pulse sequence | ~102

# FIG. 1

**FIG. 2**

FIG. 3

FIG. 4

FIG. 5

FIG. 6A

FIG. 6B

FIG. 6C

FIG. 6D

EP 2 544 017 A1

FIG. 7

EP 2 544 017 A1

FIG. 8

# EP 2 544 017 A1

Europäisches
Patentamt
European
Patent Office
Office européen
des brevets

## EUROPEAN SEARCH REPORT

Application Number

EP 11 17 2486

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 072 183 A (MCKINNON GRAEME [CH] ET AL) 10 December 1991 (1991-12-10) * the whole document * ----- | 1,2,5,7, 12,13 | INV. G01R33/36 |
| X | SAUZADE M ET AL: "SIMULATION AND TEST OF A SLICE PROFILE FOR N.M.R. IMAGING SYSTEM", PROCEEDINGS OF THE ANNUAL CONFERENCE OF THE IEEE / ENGINEERING IN MEDICINE AND BIOLOGY SOCIETY. FORT WORTH, NOV. 7 - 10, 1986; [PROCEEDINGS OF THE ANNUAL INTERNATIONAL CONFERENCE OF THE ENGINEERING IN MEDICINE AND BIOLOGY SOCIETY], NEW YORK, IEEE, US, vol. 2, no. 8, 7 November 1987 (1987-11-07), pages 1139-1141, XP000572383, * the whole document * ----- | 1,2,5,7, 12,13 | |
| X | US 2008/231282 A1 (GRISWOLD MARK A [US] ET AL) 25 September 2008 (2008-09-25) * paragraphs [0004], [0005], [0023] - [0047]; figures 4-13 * ----- | 1,2,5,7, 12,13 | TECHNICAL FIELDS SEARCHED (IPC) G01R |
| X | US 4 021 726 A (GARROWAY ALLEN NATHAN ET AL) 3 May 1977 (1977-05-03) * column 3, line 51 - column 4, line 12 * * column 6, line 65 - column 7, line 45 * * column 8, line 23 - column 8, line 49 * * column 11, line 5 - column 13, line 4 * * figures 3,8,10,12,16 * ----- | 1,2,5,7, 12,13 | |
| X | EP 2 015 094 A1 (KENERGY INC [US]) 14 January 2009 (2009-01-14) * paragraphs [0007] - [0010], [0032] - [0056]; figures 2-6,8,10-13 * ----- | 1,2,5,7, 12,13 | |

-/--

~~The present search report has been drawn up for all claims~~

| Place of search | Date of completion of the search | Examiner |
|---|---|---|
| Munich | 21 November 2011 | Lersch, Wilhelm |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches Patentamt
European Patent Office
Office européen des brevets

## EUROPEAN SEARCH REPORT

Application Number

EP 11 17 2486

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 789 922 A (OCHI HISAAKI [JP] ET AL) 4 August 1998 (1998-08-04) * column 1, line 13 - column 1, line 49 * * column 2, line 50 - column 3, line 4 * * column 6, line 28 - column 6, line 59 * * figures 1-3,6 * ----- | 1,2,12, 13 | |
| X | BLUMICH B ET AL: "NMR with excitation modulated by Frank sequences", JOURNAL OF MAGNETIC RESONANCE, ACADEMIC PRESS, ORLANDO, FL, US, vol. 199, no. 1, 1 July 2009 (2009-07-01), pages 18-24, XP026144008, ISSN: 1090-7807, DOI: 10.1016/J.JMR.2009.03.009 [retrieved on 2009-03-28] * the whole document * ----- | 1,2,12, 13 | |

TECHNICAL FIELDS
SEARCHED      (IPC)

~~The present search report has been drawn up for all claims~~

| Place of search | Date of completion of the search | Examiner |
|---|---|---|
| Munich | 21 November 2011 | Lersch, Wilhelm |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

Application Number

EP 11 17 2486

---

**CLAIMS INCURRING FEES**

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

**LACK OF UNITY OF INVENTION**

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1, 2, 5, 7, 12, 13

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

The Search Division considers that the present European patent application does not comply with the
requirements of unity of invention and relates to several inventions or groups of inventions, namely:

1. claims: 1, 2, 5, 7, 12, 13

    MRI system comprising a transmitter which has a fixed output
    amplitude and a modulated output and which generates rf
    pulses by switching rf emissions at the fixed output
    amplitude on and off and by controlling the modulated
    output. Pulses generated at the fixed output amplitude may
    form a pulse-density modulated rf pulse.
    This invention possesses no special technical features and,
    correspondingly, does not solve any objective technical
    problem.
    ---

2. claims: 3, 4

    The transmitter generates a phase- or frequency-modulated
    multidimensional rf pulse.
    The special technical features of this invention relate to
    the generation of a particular type of pulse with constant
    amplitude and modulated phase/frequency, viz. a
    multidimensional pulse. They solve the problem of generating
    a spatially-selective pulse in a cost-efficient manner.
    ---

3. claim: 6

    The dwell time of the transmitter is shorter than the filter
    time constant of the radio-frequency antenna.
    This special technical feature solves the problem of
    reducing sidebands in the frequency domain of the
    pulse-density modulated rf pulse.
    ---

4. claim: 8

    The timing of the rf pulses is distributed in time to
    minimize spurious sidebands of the pulse-density modulated
    rf pulse.
    This special technical feature solves the same problem as
    the third invention, but in a different way.
    ---

5. claims: 9-11

    The transmitter comprises multiple transmit channels and
    each element of a multi-element antenna is connected to one
    of the transmit channels.
    This special technical feature solves the problem of adding
    flexibility to the generation of the rf pulses.
    ---

## ANNEX TO THE EUROPEAN SEARCH REPORT
## ON EUROPEAN PATENT APPLICATION NO.

EP 11 17 2486

This annex lists the patent family members relating to the patent documents cited in the above-mentioned European search report.
The members are as contained in the European Patent Office EDP file on
The European Patent Office is in no way liable for these particulars which are merely given for the purpose of information.

21-11-2011

| Patent document cited in search report | | Publication date | Patent family member(s) | | Publication date |
|---|---|---|---|---|---|
| US 5072183 | A | 10-12-1991 | DE | 3829374 A1 | 22-03-1990 |
| | | | EP | 0357141 A2 | 07-03-1990 |
| | | | JP | 2107231 A | 19-04-1990 |
| | | | JP | 2838102 B2 | 16-12-1998 |
| | | | US | 5072183 A | 10-12-1991 |
| US 2008231282 | A1 | 25-09-2008 | NONE | | |
| US 4021726 | A | 03-05-1977 | DE | 2540436 A1 | 25-03-1976 |
| | | | JP | 1289682 C | 14-11-1985 |
| | | | JP | 51053888 A | 12-05-1976 |
| | | | JP | 60012574 B | 02-04-1985 |
| | | | US | 4021726 A | 03-05-1977 |
| EP 2015094 | A1 | 14-01-2009 | EP | 2015094 A1 | 14-01-2009 |
| | | | US | 7397243 B1 | 08-07-2008 |
| US 5789922 | A | 04-08-1998 | JP | 3345527 B2 | 18-11-2002 |
| | | | JP | 8308809 A | 26-11-1996 |
| | | | US | 5789922 A | 04-08-1998 |

EPO FORM P0459

For more details about this annex : see Official Journal of the European Patent Office, No. 12/82